# EUROPEAN PATENT APPLICATION

(11) **EP 0 522 280 A1**
(43) Date of publication of application: **13.01.1993**
(21) Application number: 92109200.3
(22) Date of filing: 01.06.1992
(51) Int. Cl.: H03K 17/96

(54) **Electric control signal-generating assembly**

(30) Priority: 03.06.1991 IL 98353; 21.05.1992 IL 101959
(71) Applicant: BARAN ADVANCED TECHNOLOGIES (86) LTD, Beer-Sheva 84131 (IL)
(72) Inventor: Yeheskel, Menashe, Yavne 70600 (IL); Rosenberg, Armand, Rehovot (IL)
(74) Representative: Dragotti, Gianfranco

(57) **Abstract**

An electric control signal-generating assembly, comprises:
- a housing (10) having at least one elastically deformable surface (11);
- a Force-Sensing Resistor (FSR) (12) positioned within the said housing (10) and in contact with the said elastically deformable surface (11);
- a Zebra connector (15), electrically to connect between the output contacts of the said FSR (12) and input contacts of signal-processing means;
- signal-processing means, to receive the signal generated by the FSR (12), through the Zebra connector (15), and to generate a corresponding control signal;
- positioning means, to keep the FSR (12), the Zebra connector (15) and the signal-processing means in the desired positioned relationship; and
- closure means, substantially to seal the housing against the environment.

## Description

The present invention relates to an electric control signal-generating assembly. More particularly, the invention relates to such assemblies which utilize force-sensing resistors for the primary generation of signals.

Force-sensing elements, also known under the name of strain gauges, have been known in the art for a long time and have been widely used in a number of special applications, e.g. in research work. Because of the prices and limited performance, force-sensing elements have not found widespread use in everyday applications. A use of force-sensing elements, which is of particular interest, is the construction of environmentally protected switches, to be used in hostile environments, or in applications in which these switches are not gently handled, e.g., in building elevators, or the like applications, which require switches without moving parts, in order to achieve a high reliability and low failure rates.

So far switches of this type have been manufactured using piezo-electric material as the primary signal-generating material. In these uses the piezo-electric material has been attached to the sensing area of the housing of the switch, whereby the signal produced by the piezo-electric material when a stress is applied to it by a pressure of the finger or a similar pressure is fed to an electronic circuit which connects or disconnects the electric circuit which is connected through the switch.

However, piezo-electric switches present a number of drawbacks. First of all, the piezo-electric material is only capable of delivering a signal pulse-wise, viz. for a very short period of time, regardless of the time during which pressure is applied, e.g., by the finger, on the piezo-electric material. Therefore, piezo-electric switches behave as "one-shot" switches, providing only rudimental connecting or disconnecting functions. Taking, for instance, building elevators as an example, this means that piezo-electric switches are unsuitable for door opening, because normal door opening switches in elevators are designed so as to keep doors open as long as the rider applies a pressure with the finger.

With piezo-electric switches this is not possible, because after the first signal is generated by the application of the finger additional pressure does not produce any other signal.

Furthermore, piezo-electric materials and the keys or switches made therefrom, are sensitive to fast temperature changes, and therefore it happens that they respond to changes of the ambient temperature as if a force had been applied to them, and spontaneously generate unsolicited signals. Additionally, piezo-electric based switches cannot be conveniently used in areas in which vibrations are substantial, because unintentional impacts and vibrations transmitted through the switch housing to the piezo-electric element can generate a signal which includes any number of harmonics, and when the signal is amplified the apparent characteristic of the switch is such that the switch undergoes bouncing. An additional disadvantage is that relatively weak impacts on the activating area of the switch easily damage the piezo-electric material, and therefore switches made from piezo-electric material are not highly reliable.

It is therefore clear that it would be highly desirable to be able to overcome the aforesaid disadvantages and to provide a switch which is highly reliable and inexpensive as compared to switches used in the art.

It is an object of the present invention to provide an electric control signal-generating assembly, which can be used as a switch in a variety of applications, which overcomes the aforesaid drawbacks and which is inexpensive as compared with the switches known in the art.

The characteristics and the advantages of the electric control signal-generating assembly of the present invention will be more clear from the following detailed description of one preferred and non-limiting embodiment of the assembly.

In the drawings:
- fig. 1 is a schematic representation of a Force-Sensing Resistor;
- figs. 2-4 illustrate an assembly according to one embodiment of the invention;
- figs. 5 and 6 illustrate an assembly according to another embodiment of the invention.

The electric control signal-generating assembly according to the invention comprises:
- a housing having at least one elastically deformable surface;
- a Force-Sensing Resistor (FSR), positioned within the said housing and in contact with the said elastically deformable surface;
- a Zebra electrical connector to connect between the output contacts of the said FSR and input contacts of signal-processing means;
- signal-processing means, to receive the signal generated by the FSR, through the Zebra connector, and to generate a corresponding control signal;
- positioning means, to keep the FSR, the Zebra connector and the signal-processing means in the desired positioned ralationship; and
- closure means, substantially to seal the housing against the environment;
- signal output means being provided to convey the control signal generated by the assembly to the controlled device.

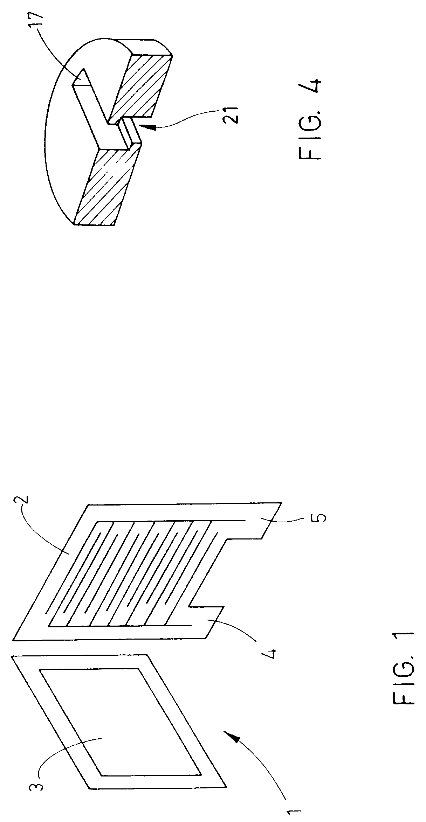

The construction of a typical Force Sensing Resistor, 1, is shown in Fig. 1, and is based on two polymer films or sheets. A conducting pattern is deposited on the polymer sheet 2 in the form of a set of interdigiting fingers. The finger pattern is typically on the order of 0.4 mm finger width and spacing, but other spacings can be used, as well. Next, a semi-conductive polymer is deposited on the other sheet, 3. The sheets are facing together so that the conducting fingers are shunted by the conducting polymer. When no force is applied to the sandwich, the resistance between the interdigiting fingers is quite high. With increasing force, the resistance drops, following an approximate power law. The resistor output can be transmitted to a device which uses the signal generated by it, via connections 4 and 5. FSRs can be, e.g., of the type manufactured by Interlink Electronics, U.S.A.

By "Zebra conductor" is meant an element built of combined conductive and non-conductive compressible material, such as Silicone Rubber.

Preferably, such conductor is built of a plurality of layers, such layers being alternately conductive and non-conductive, so that electricity is transmitted only along the conductive layer. However, other arrangements comprising conductive zones embedded in non-conductive material are also contemplated by the invention. Such devices, which are normally in the shape of a block or cube, are well known in the art, and require no particular description. They can be made of a variety of material, e.g. rubber, in which case the conductive layers will be made of conductive rubber, which is rubber that incorporates conductive material, such as graphite. An example of such connectors are the silicone rubber connectors made by You-Eal Corporation, Korea.

The housing can be made of any suitable material, e.g., plastic material or metal, or a combination of these or other materials, and the actual material of which it is made is not important, as long as it leads to a substantially sealed housing, and is elastically deformable at the surface which is in contact with the FSR. As will be appreciated by the skilled engineer, thin metal is easily elastically deformable by small pressures, as is synthetic material, and the choice of material would be dictated by the particular use of the assembly.

According to a preferred embodiment of the invention, the signal-processing means comprise a printed circuit board (PCB), which acts as an amplifier of the primary signal generated by the FSR, and elaborates this signal according to predetermined criteria, e.g., to determine the length of the signal, its intensity and to generate corresponding amplified and/or elaborated signals which can be used to control one or more devices, e.g., to control the operation of an elevator.

As will be apparent, a variety of positioning means can be provided, and the purpose of these positioning means is only to keep the various parts in their proper place. According to a preferred embodiment of the invention, the positioning means comprise a solid element shaped to house the FSR and/or the Zebra connector, and/or the signal-processing means, or portions thereof, in the desired positioned relationship with one other. The positioning means can be kept in contact with pressure-generating means which are used to apply a pressure on the FSR, directly or through the positioning means, as the case may be, thereby ensuring that no substantial displacement thereof is possible when deformation of the housing surface takes place. This, as will be apparent to the skilled person, is necessary in order to generate a primary signal. If care is not taken to keep the FSR in place, when a pressure is applied, e.g., by a finger, and the surface of the housing is deformed inwardly, the FSR moves away from the surface and the force applied by the finger may result in the mere displacement of the FSR, with non generation of signal resulting from the application of a pressure on the FSR when it cannot move from its place.

As stated, part of the various elements can be housed in a solid element, and it may be desirable in some cases to have extremities of elements partly housed in such solid element outside and free to move within the housing. Accordingly, in such cases it may be desirable to provide stopper means which will avoid the displacement of such extremities of partly housed elements, and will keep them in their proper place.

At stages, the primary signal generated by the FSR is elaborated or amplified by the signal-processing means, and the new signal so generated must be transmitted to the control device. This can be made in a variety of ways, all of which are apparent to the skilled engineer, but normally it will be desirable to provide electric wirings or electric pins which protrude outside the housing of the assembly, and which can be used to connect to controlled devices.

In order to keep the various elements in place, it is desirable in many cases to fill any empty spaces remaining after assembly of the various parts of the switch with filler material, which is preferably a hard, substantially undeformable filler, so that all parts are kept firmly in place. In one embodiment of the invention, the filler material is a polymeric material, preferably a polymeric material which is polymerizable in situ, and therefore can be injected into the housing and completely fills every empty space while so defining correctly and fully.

As will become apparent as this description proceeds, the assembly according to the invention has as a considerable advantage the ease and simplicity of assembly, because of the way the various parts are connected and constructed, which in turn, leads to reduction of cost.

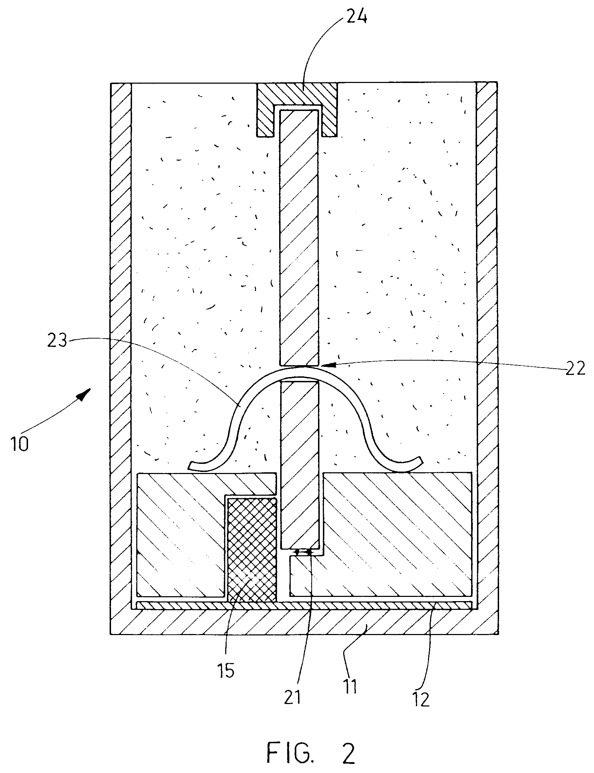

Turning now to Fig. 2, the housing, generally indicated by numeral 10, is cylindrical in shape, according to this particular embodiment of the invention. Surface 11 is elastically deformable, and constitutes the actuating area of the switch, on which pressure is applied by the finger.

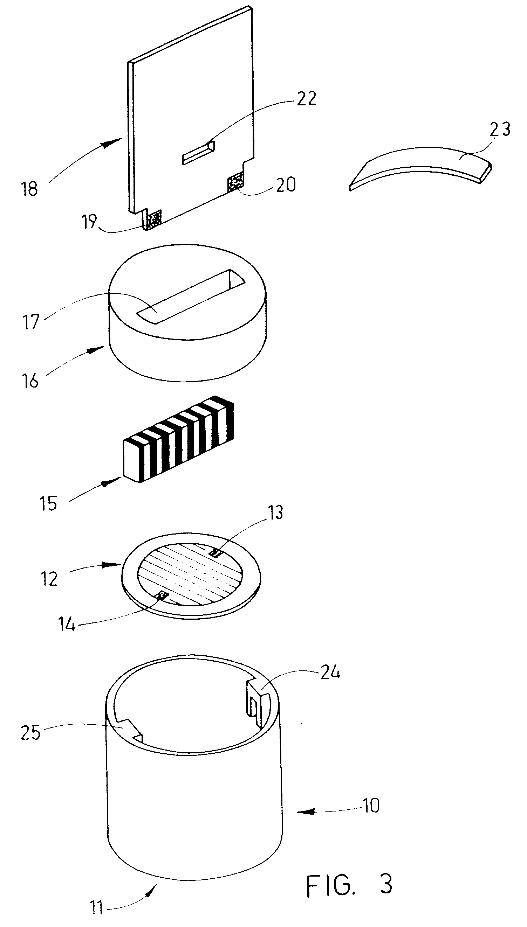

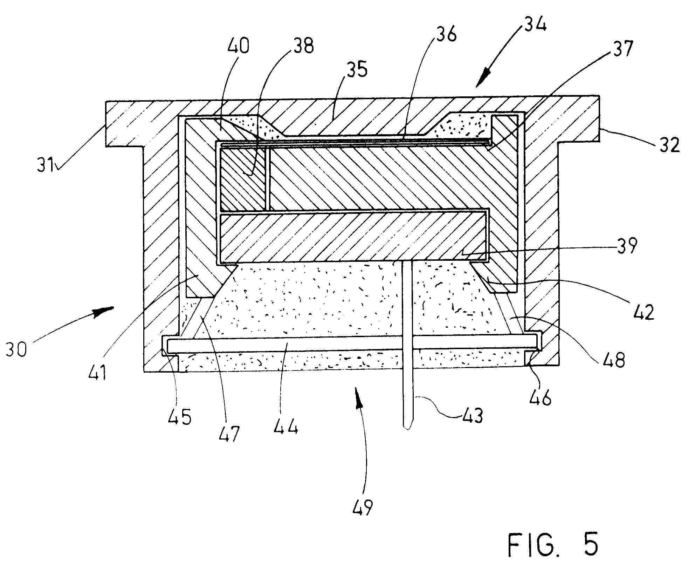

This embodiment will be better understood by looking simultaneously at Figs. 2,3 and 4. The FSR, 12, has the shape of a circular disk, and is provided with two electrodes, 13 and 14. As seen in Fig. 2, the FSR is in contact with the inner part of surface 11, which is in electrical contact with contacts 13 and 14. A solid element, 16 (Fig. 3) houses the Zebra on one side, in a slot provided therein (not seen in the figure), and has an additional slot, 17, which is capable of housing a portion of a printed circuit board (PCB) 18, which is provided with electric contacts 19 and 20, so that such contacts 19 and 20 are in electric contact with Zebra connector 15. The shape of the slots and the way they provide for the desired positioned relationship is seen in Fig. 4 and in Fig. 2. In Fig. 4 slot 21 is seen to be displaced with respect to slot 18, which houses the Zebra connector. Accordingly, contacts 19 and 20, which would be positioned in slot 21, will contact Zebra 15 at the proper place.

The PCB 18 is further provided with slot 22, which is used to house spring 23, which is used as the pressure-generating means to apply a pressure on the solid element 16, so that in turn it applies a pressure on the FSR 12 on surface 11, and additionally keeps PCB 18, Zebra connector 15 and FSR 12 in their proper positioned relationship.

Since PCB 18 is only partially housed in solid element 16, and extends substantially outside the solid element, stopper means 24 and 25 are provided, to keep it in place and to prevent it from moving freely within the housing .

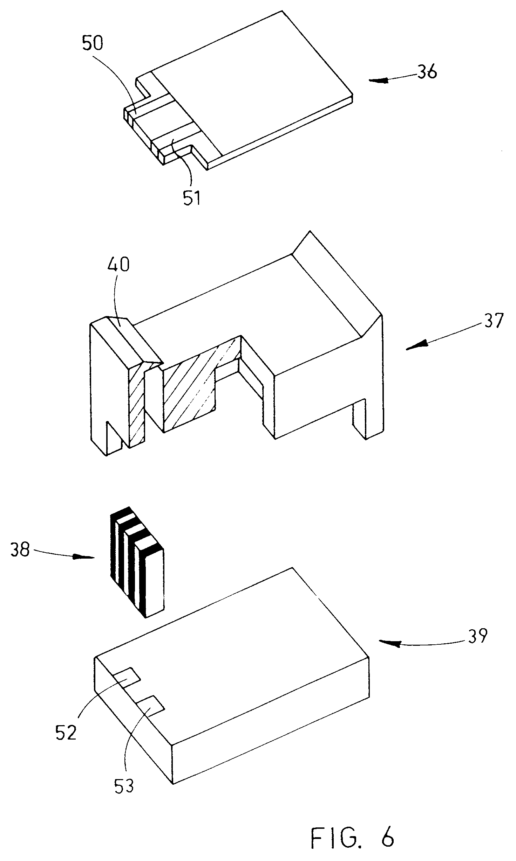

Turning now to Figs. 5 and 6, an assembly according to one embodiment of the invention is seen. This assembly comprises a housing 30, provided with shoulders 31 and 32, which are used to stop the assembly when an opening of smaller diameter is provided for housing it. The elastically deformable surface 34 is provided with an inner protrusion 35, which is in contact with the active area of the FSR 36, and which applies a force thereon when a pressure is applied, e.g., by pushing it with a finger. A solid element 37 is provided, which not only houses the Zebra connector 38, but also keeps the FSR 36 and a PCB 39 in their proper position. This is achieved by providing shoulders 40, 41 and 42, the role of which is self-evident from the figure. The PCB 39 uses, as output means, pin or pins 43.

The pressure-generating means 44 consist of a disk kept in place by slots 45 and 46, provided in housing 30, which ring element 44 is provided with arms 47 and 48, which apply a pressure on shoulders 41 and 42. A lid (not shown) is provided to close the open end 49 of the housing, which housing is further filled with filler material, as explained above.

Looking at Fig. 6, it can be seen that FSR 36 is provided with contacts 50 and 51, which are in contact, in the assembled position, with conductive strips of the Zebra element 38, which in turn is in contact with contacts 52 and 53 of the printed circuit board 39.

As will be apparent to the skilled person, the assembly of the invention offers many advantages over the prior art devices, and furthermore can be constructed in many different ways, while exploiting all the advantages of the invention. It will also be clear that the actual shape of the housing can differ in different applications, and it is mainly dictated by the particular use by the way for which the assembly is designed.

Accordingly, many different assemblies can be provided, containing different shapes of the Force-Sensing Resistors, of the solid elements, of the signal-processing means, which conveniently comprise a printed circuit board, but which can also comprise additional and/or different electronic elements, and also the Zebra connector which, as is known to the skilled person, can be of many different shapes. All these changes can be effected by the skilled engineer, without exceeding the scope of the invention.

## Claims

1. An electric control signal-generating assembly, characterized in that it comprises:
- a housing having at least one elastically deformable surface;
- a Force-Sensing Resistor (FSR) positioned within the said housing and in contact with the said elastically deformable surface;
- a Zebra connector, electrically to connect between the output contacts of the said FSR and input contacts of signal-processing means;
- signal-processing means, to receive the signal generated by the FSR, through the Zebra connector, and to generate a corresponding control signal;
- positioning means, to keep the FSR, the Zebra connector and the signal-processing means in the desired positioned realtionship; and
- closure means, substantially to seal the housing against the environment;
- signal output means being provided to convey the control signal generated by the assembly to the controlled device.

2. An assembly according to claim 1, characterized in that the housing is made of metal or of plastic material, or of a combination thereof.

3. An assembly according to claim 1, characterized in that the signal-processing means comprise a printed circuit board.

4. An assembly according to claim 1, characterized in that the positioning means comprise a solid element shaped to house the FSR and/or the Zebra connector and/or the signal-processing means, or portions thereof, in the desired positioned relationship with one another.

5. An assembly according to claim 4, further characterized in comprising pressure-generating means to apply a pressure on the FSR, thereby ensuring that no substantial displacement thereof is possible when deformation of the housing surface takes place.

6. An assembly according to claim 4 or 5, further characterized in comprising stopper means to avoid the displacement of elements only partly housed within the solid element.

7. An assembly according to claim 1, characterized in that the signal output means comprise electric wirings.

8. An assembly according to claim 1, characterized in that the signal output means comprise one or more pins.

9. An assembly according to claim 1, characterized in that the empty volume within the housing is filled with filler material.

10. An assembly according to claim 9, characterized in that the filler material is a hard, substantially undeformable, material.

11. An assembly according to claim 9, characterized in that the filler material is a polymeric material.

12. An assembly according to claim 11, characterized in that the filler material is polymerizable in situ.
